# EUROPÄISCHE PATENTSCHRIFT

(11) **EP 0 494 383 B1**
(45) Veröffentlichungstag und Bekanntmachung des Hinweises auf die Patenterteilung: **14.08.1996**
(21) Anmeldenummer: 91121087.0
(22) Anmeldetag: 09.12.1991
(51) Int. Cl.: G03F 7/039, G03F 7/075

(54) **Photoresist**
photoresist
Photoréserve

(30) Priorität: 20.12.1990 DE 4041001
(43) Veröffentlichungstag der Anmeldung: 15.07.1992
(73) Patentinhaber: SIEMENS AKTIENGESELLSCHAFT, 80333 München (DE)
(72) Erfinder: Sezi, Recai, Dr., W-8551 Röttenbach (DE); Rainer, Leuschner, Dr., W-8520 Erlangen (DE); Borndörfer, Horst, Dipl.-Chem., W-8520 Erlangen (DE); Sebald, Michael, Dr., W-8521 Hessdorf-Hannberg (DE); Birkle, Siegfried, Dr., W-8552 Höchstadt (DE); Ahne, Hellmut, Dr., W-8551 Röttenbach (DE)

(56) Entgegenhaltungen:
- EP-A- 0 102 450
- US-A- 4 508 812

## Beschreibung

Die Erfindung betrifft einen Photoresist zur Strukturerzeugung im Submikron-Bereich.

Aus der EP-OS 0 388 484 ist ein wäßrig-alkalisch entwickelbarer, hochauflösender Photoresist zur Strukturerzeugung im Submikron-Bereich bekannt. Dieser Resist besteht aus einem entwikkelbaren Basispolymer und einer photoaktiven Komponente (sowie gegebenenfalls weiteren üblichen Zusätzen), wobei das Basispolymer als entwickelbare - und somit lösungsvermittelnde - Gruppen Anhydridfunktionen aufweist. Die anhydridhaltigen Basispolymere, die DUV-transparent sind und sich sowohl für die Einlagen- als auch für die Zweilagentechnik eignen, enthalten vorzugsweise 10 bis 55 Mol-% Maleinsäureanhydrid und werden durch Co- bzw. Terpolymerisation mit Allyltrimethylsilan und Styrol sowie gegebenenfalls mit einem weiteren Monomer, beispielsweise Maleinimid, erhalten.

Photoresists mit derartigen Basispolymeren, die als photoaktive Komponente Diazonaphthochinon- oder Diazoketonderivate aufweisen, benötigen bei DUV-8elichtung, beispielsweise bei einer Wellenlänge von 248 nm, für eine maßhaltige Belichtung eine Dosis von etwa 70 bis 80 mJ/cm². Diese relativ hohe Dosis kan, von Nachteil sein, weil bei Fertigungslinien, beispielsweise für hochintegrierte mikroelektronische Bauelemente, bei einem geringen Durchsatz eine lange Belegung der kostenintensiven Belichtungsgeräte (Stepper) erforderlich ist; in der Fertigung wird deshalb im allgemeinen eine Empfindlichkeit < 20 mJ/cm² gefordert. Bei der Verwendung von siliciumhaltigen Resists der genannten Art in der Zweilagentechnik ergibt sich noch das Problem, daß nach der Strukturübertragung im Sauerstoffplasma im Bottomresist Submikron-Strukturen erhalten werden, die gegenüber den Strukturen im Topresist mehr als 10 % an Maß verloren haben; dies ist für die Fertigung aber nicht tolerierbar.

Aus der EP-OS 0 395 917 ist ein Photostrukturierungsverfahren bekannt, welches die photolithographische Übertragung von Submikron-Strukturen in der Zweilagentechnik erlaubt. Bei diesem Verfahren werden die Vorteile von anhydridhaltigen Basispolymeren bzw. Resists genutzt, und gleichzeitig wird eine maßhaltige Übertragung ermöglicht, d.h. es wird bei der Zweilagentechnik im Bottomresist das exakte Maskenmaß reproduziert. Dies geschieht durch eine chemische Aufweitung der anhydridhaltigen Strukturen im Topresist in einem Ausmaß, das genau dem Maßverlust entspricht, der bei der Strukturübertragung im Sauerstoffplasma auftritt. Auch bei diesem Verfahren ist aber zur Strukturierung des Topresists eine relativ hohe Dosis erforderlich, nämlich etwa 90 mJ/cm² (im DUV-Bereich).

Durch das genannte Photostrukturierungsverfahren wurde ferner erstmals die Möglichkeit eröffnet, Strukturdimensionen zu erzeugen, die kleiner sind als es durch die physikalische Auflösungsgrenze der angewendeten Lithographietechnik vorgegeben wird, d.h. es wird in der Photoresiststruktur die Grabenbreite bis unter die Auflösungsgrenze verkleinert. Dies erfolgt durch eine chemische Aufweitung der anhydridhaltigen Resiststrukturen um ein Maß von einigen Nanometern bis zu einigen Mikrometern, womit eine entsprechende Grabenverengung einhergeht. Bei dieser Vorgehensweise, die sowohl bei der Einlagen- als auch bei der Zweilagentechnik möglich ist, werden Resists mit Diazoketonderivaten als photoaktive Komponente eingesetzt, diese Resists genügen aber den Fertigungsansprüchen hinsichtlich der Empfindlichkeit nicht.

Aus der EP-OS 0 102 450 (bzw. der entsprechenden US-Patentschrift 4 491 628) ist eine positiv oder negativ arbeitende Resistzusammensetzung bekannt, bei der das Problem der ungenügenden Empfindlichkeit herkömmlicher Resists mit dem Konzept der sogenannten chemischen Verstärkung angegangen wird. Die Resistzusammensetzung weist dazu ein Polymer mit säurelabilen Resten und einen Photoinitiator auf, der bei Belichtung eine Säure freisetzt. Dabei werden Basispolymere verwendet, die alkalilösliche Gruppen, beispielsweise phenolische OH-Gruppen (in einem Vinylphenol-Polymer), besitzen, welche durch säurespaltbare Gruppen, beispielsweise eine tert.-Butyl- oder tert.-Butoxycarbonylgruppe, blockiert sind; das Polymer ist somit zunächst alkaliunlöslich. Als Photoinitiator (bzw. Photosäure), der bei Belichtung mit DUV-Licht, Elektronen- oder Röntgenstrahlen eine starke Säure bildet, dienen sogenannte Crivellosalze, d.h. Oniumsalze, wie Triphenylsulfonium-hexafluorophosphat.

Die hohe Empfindlichkeit von Resistzusammensetzungen der vorstehend genannten Art erklärt sich daraus, daß bei einer auf die Belichtung folgenden Temperaturbehandlung ("post exposure bake") ein einziges Proton, welches bei der Belichtung aus der Photosäure erzeugt wurde, und zwar durch ein Photon, katalytisch eine Vielzahl der säurespaltbaren Gruppen abspaltet, d.h. eine Vielzahl von alkalilöslichen Gruppen freisetzt. Bei herkömmlichen Resists mit Diazoverbindungen (als photoaktive Komponente) kann dagegen pro Photon maximal nur eine einzige alkalilösliche Säuregruppierung erzeugt werden. Für die genannten Resistzusammensetzungen wird eine Empfindlichkeit angegeben, die bei UV-Belichtung von 5 bis 55 mJ/cm² reicht bzw. bei Elektronenstrahlbelichtung bei 10 µC/cm² liegt; außerdem zeigen sie einen hohen Kontrast. Von Nachteil ist bei diesen Systemen aber, daß eine maßhaltige Strukturübertragung nicht möglich ist, daß keine engen Gräben erzeugt werden können, d.h. Gräben mit einer Breite kleiner als die Auflösungsgrenze, und daß entweder die DUV-Transparenz oder die Ätzresistenz gegen Substratätzprozesse relativ gering ist.

Aus der EP-OS 0 234 327 (bzw. den entsprechenden US-Patentschriften 4 837 124 und 4 912 018) ist eine Photoresistzusammensetzung für DUV- und Excimerlaser-Lithographie bekannt, welche ebenfalls nach dem Konzept der chemischen Verstärkung arbeitet. Die Resistzusammensetzung weist dazu 1 bis 50 % einer latenten Photosäure und 50 bis 99 % eines filmbildenden, Imidgruppen enthaltenden Polymers auf, zusammen gelöst in einem Lösungsmittel. Dabei ist eine genügende Anzahl der Imidgruppen mit säurelabilen Gruppen blockiert, um das Polymer alkaliunlöslich zu machen; derartige Gruppen sind Oxycarbonylgruppen, insbesondere die tert.-Butoxycarbonylgruppe. Die säurelabilen Gruppen werden mittels der Photosäure - in der beschriebenen Weise - abgespalten, wodurch das Polymer - aufgrund der dabei entstehenden Imidgruppen - alkalilöslich wird. Der Vorteil dieser Resistzusammensetzung ist ein verbessertes Auflösungsvermögen, sie weist aber dieselben Nachteile auf wie die Resistzusammensetzung nach der EP-OS 0 102 450. Außerdem ist von Nachteil, daß die Einführung der säurelabilen Gruppen mittels einer polymeranalogen Reaktion nicht steuerbar ist und nicht reproduzierbar verläuft und damit auch nicht quantitativ erfolgt.

Aufgabe der Erfindung ist es, einen Photoresist bereitzustellen, der eine maßhaltige Strukturübertragung in der Zweilagentechnik und die Erzeugung von Strukturen (Gräben bzw. Löcher) jenseits der Auflösungsgrenze erlaubt, eine hohe Transparenz aufweist, empfindlich für UV-Licht, Elektronen- und Röntgenstrahlen ist und eine hohe Empfindlichkeit (< 20 mJ/cm² im DUV-Bereich) sowie ein hohes Auflösungsvermögen, auch im Subhalbmikron-Bereich, besitzt.

Dies wird erfindungsgemäß dadurch erreicht, daß der Photoresist folgende Komponenten enthält:
- eine Polymerkomponente mit Carbonsäureanhydridfunktionen und Carbonsäure-tert.-butylestergruppen,
- einen bei Belichtung eine Säure freisetzenden Photoinitiator und
- ein geeignetes Lösungsmittel.

Beim Photoresist nach der Erfindung ist wesentlich, daß die Polymerkomponente zwei verschiedene Arten von funktionellen Gruppierungen aufweist, nämlich Anhydridfunktionen und tert.-Butylestergruppen. Dabei können diese beiden Gruppierungen in verschiedenen Polymeren vorhanden sein, vorteilhaft liegen sie jedoch in ein und demselben Polymer vor.

Den Anhydridfunktionen liegt vorzugsweise Maleinsäureanhydrid zugrunde; eine andere Verbindung dieser Art ist beispielsweise Itaconsäureanhydrid. Die Polymere können sowohl cyclische Anhydridfunktionen aufweisen, wobei diese in der Haupt- oder in der Seitenkette angeordnet sein können, als auch nicht-cyclische, d.h. lineare Anhydridfunktionen. Eine Reihe von entsprechenden Monomeren sind aus der EP-OS 0 388 484 bekannt, beispielsweise Acryl- bzw. Methacrylsäureanhydrid und Vinylphthalsäureanhydrid.

Den Carbonsäure-tert.-butylestergruppen liegen vorzugsweise Acryl- und Methacrylsäure-tert.-butylester sowie Malein- und Fumarsäure-tert.-butylester zugrunde. Andere Verbindungen dieser Art sind beispielsweise Vinylbenzoesäure-tert.-butylester und Zimtsäure-tert.-butylester.

Mischpolymere aus Carbonsäure-tert.-butylestern und Carbonsäureanhydriden, die beim erfindungsgemäßen Photoresist Verwendung finden können, sin Gegenstand der deutschen Patentanmeldung Akt.Z. P 40 41 000.5 (entspricht EP-A-0 492 255)- "Mischpolymere". Die Mischpolymere können dabei nicht nur als Copolymere (der vorstehend genannten Art), sondern auch als Terpolymere aufgebaut sein. In derartige Polymere ist zusätzlich eine ungesättigte Verbindung eingebaut, beispielsweise eine ungesättigte aromatische Verbindung, wie Styrol, α-Methylstyrol und Vinylnaphthalin. Eine andere ungesättigte Verbindung, die vorteilhaft in die Polymere eingebaut werden kann, ist beispielsweise Allyltrimethylsilan.

Vorzugsweise finden beim erfindungsgemäßen Photoresist Acrylsäure- bzw. Methacrylsäure-tert.-butylester/Maleinsäureanhydrid-Copolymere Verwendung. Vorteilhaft können beispielsweise aber auch Terpolymere eingesetzt werden, die aus einen tert.-Butylester einer ungesättigten Carbonsäure, Maleinsäureanhydrid und Allyltrimethylsilan oder Styrol enthaltenden Monomermischungen hergestellt werden; die Polymerisation wird vorzugsweise radikalisch initiiert. Die Polymere zeichnen sich durch eine hohe Transparenz sowohl im nahen als auch im tiefen UV-Bereich aus und eignen sich daher in hervorragender Weise für die Verwendung in Hochkontrast-DUV-Photoresists, beispielsweise für Belichtungen mit KrF-Excimerlaser-Belichtungsgeräten (bei einer Wellenlänge von 248 nm).

Als Photoinitiator, der im vorliegenden Fall auch als Photosäure bezeichnet wird, können im erfindungsgemäßen Resist an sich bekannte Verbindungen eingesetzt werden (siehe dazu beispielsweise EP-OS 0 102 450 und 0 234 327). Wichtig für die Auswahl des Photoinitiators ist allein die geforderte Eigenschaft, bei Belichtung eine Säure freizusetzen. Die Belichtung erfolgt dabei mit UV-Licht oder mit Elektronen- bzw. Röntgenstrahlen, wobei vorteilhaft eine starke Säure gebildet wird. Die Säure bewirkt dann eine Abspaltung des tert.-Butylesters aus der Carbonsäure-tert.-butylestergruppe, und zwar bei einer der Belichtung folgenden Temperaturbehandlung. Durch diese säurekatalysierte Entblockierung wird das zunächst alkaliunlösliche Polymer alkalilöslich.

Beim erfindungsgemäßen Resist ist der Photoinitiator vorzugsweise ein Oniumsalz. Derartige Verbindungen, die auch als Crivellosalze bezeichnet werden, sind beispielsweise Diphenyljodonium- und Triphenylsulfonium-triflat (mit Triflat wird der Trifluormethansulfonylrest bezeichnet). Weitere einsetzbare Photoinitiatoren sind beispielsweise Triazinderivate. Der Photoinitiator wird im allgemeinen in einer Konzentration von 1 bis 20 Masse-% eingesetzt, bezogen auf den trockenen Photoresist, d.h. die lösungsmittelfreie Resistzusammensetzung.

Als Lösungsmittel dienen an sich bekannte Resistlösungsmittel. Wichtig für die Auswahl des Lösungsmittels ist allein das Erfordernis, daß sowohl die Polymerkomponente als auch der Photoinitiator gelöst werden muß. Außerdem müssen - mit den bekannten Beschichtungsverfahren - fehlerfreie Resistschichten auf den Substraten gebildet werden, beispielsweise auf Siliciumwafern oder auf mit einem Bottomresist beschichteten Wafern. Vorzugsweise ist das Lösungsmittel Cyclohexanon oder Methoxypropylacetat; daneben gelangt beispielsweise auch Diethylenglykoldimethylether zum Einsatz.

Der erfindungsgemäße Photoresist weist eine Empfindlichkeit von 1 bis 5 mJ/cm² auf. Neben den genannten Komponenten kann der Photoresist nach der Erfindung auch weitere Zusätze enthalten. Derartige Zusätze sind beispielsweise Sensibilisatoren, durch welche der Resist für Belichtungen im nahen UV-Bereich sensibilisiert werden kann, beispielsweise bei 365 nm. Ein geeigneter Sensibilisator ist dabei insbesondere Perylen.

Mit dem Photoresist nach der Erfindung können sowohl positive als auch negative Strukturen erzeugt werden. Darüber hinaus kann dieser Resist sowohl in der Einlagenresisttechnik (mit Naßentwicklung) als auch in der Zweilagenresisttechnik (mit Naß- und Trockenentwicklung) eingesetzt werden.

Bei der Einlagentechnik finden vorzugsweise solche Polymere Verwendung, welche - neben Carbonsäureanhydrid- und Carbonsäure-tert.-butylestergruppen - zusätzlich noch aromatische Gruppen aufweisen. Derartige Polymere können - in einfacher Weise - beispielsweise durch radikalische Polymerisation von Maleinsäureanhydrid und einem tert.-Butylester mit einem aromatischen Monomer, wie Styrol, und gegebenenfalls mit einem oder mehreren weiteren Monomeren, wie Vinylnaphthalin, erhalten werden. Es können aber auch andere aromatische Monomere eingesetzt werden, wie sie beispielsweise aus der EP-OS 0 388 484 bekannt sind. Dabei läßt sich - durch das Monomeren-Mischungsverhältnis - im Polymer sowohl der molare Anteil an tert.-Butylester als auch derjenige an den anderen Monomeren leicht und reproduzierbar steuern. Für die Anwendung in der Einlagentechnik werden Terpolymere aus 10 bis 55 Mol-% Maleinsäureanhydrid, 10 bis 55 Mol-% tert.-Butylester und 10 bis 70 Mol-% Styrol bevorzugt; die einzelnen Komponenten ergänzen sich dabei jeweils zu 100 %.

Bei der Zweilagentechnik finden vorzugsweise solche Polymere Verwendung, welche - neben Carbonsäureanhydrid- und Carbonsäure-tert.-butylestergruppen - zusätzlich noch siliciumhaltige Gruppen aufweisen. Derartige Polymere können - in einfacher Weise - beispielsweise durch radikalische Polymerisation von Maleinsäureanhydrid und einem tert.-Butylester mit einem siliciumhaltigen Monomer, wie Allyltrimethylsilan, und gegebenenfalls mit einem oder mehreren weiteren Monomeren, wie Styrol, erhalten werden. Es können aber auch andere siliciumhaltige Monomere eingesetzt werden, wie sie beispielsweise aus der EP-OS 0 388 484 bekannt sind. Dabei läßt sich - durch das Monomeren-Mischungsverhältnis - im Polymer sowohl der molare Anteil an tert.-Butylester als auch derjenige an den anderen Monomeren leicht und reproduzierbar steuern. Für die Anwendung in der Zweilagentechnik werden Terpolymere aus 10 bis 55 Mol-% Maleinsäureanhydrid, 10 bis 55 Mol-% tert.-Butylester und 10 bis 55 Mol-% Allyltrimethylsilan bevorzugt; die einzelnen Komponenten ergänzen sich dabei jeweils zu 100 %.

Der erfindungsgemäße Photoresist kann besonders vorteilhaft bei den Photostrukturierungsverfahren eingesetzt werden, die aus der EP-OS 0 395 917 bekannt sind, nämlich bei Verfahren zur Variation der Breite von Photoresiststrukturen. Dies ist zum einen die maßhaltige Strukturübertragung in der Zweilagentechnik und zum anderen die Erzeugung von Strukturen jenseits der Auflösungsgrenze. Bei beiden Verfahrensweisen ist für die Auswahl des Resistpolymers wichtig, daß das Polymer Anhydridgruppen aufweist. Besonders überraschend ist dabei aber die Tatsache, daß das Polymer mit Aminosiloxanen, die bei diesen Verfahren als sogenanntes Aufweitungsagens eingesetzt werden, sehr rasch reagiert und - bereits bei einer geringen Schichtdicke - sehr ätzresistente Schichten ergibt. Darüber hinaus werden nach einem Trockenätzprozeß mit O₂/RIE hochaufgelöste Strukturen mit sehr steilen Flanken erhalten. Der Photoresist nach der Erfindung ermöglicht außerdem eine hohe Prozeßsicherheit.

Im allgemeinen verläuft die Strukturerzeugung mittels des erfindungsgemäßen Resists in folgenden Stufen:
1. Aufbringen des Resists auf ein Substrat;
   der Resist muß für die Belichtungswellenlänge transparent sein, eine Ätzresistenz gegen Substratätzprozesse ist nicht erforderlich.
2. Trocknen des Resists.
3. Bildmäßige Belichtung;
   dabei wird in den belichteten Bereichen eine starke Säure erzeugt.
4. Temperaturbehandlung ("post exposure bake");
   dabei wird die Temperatur/Zeit-Kombination (auf einer Hotplate) so gewählt, daß - in den belichteten Bereichen - im Polymer eine säurekatalysierte Abspaltung der tert.-Butylestergruppen erfolgt und der Resist somit entwickelbar eingestellt wird.
5. Alkalische Entwicklung.
6. Chemische Nachbehandlung;
   dabei erfolgt eine Aufweitung der Resistlinien, d.h. eine Verengung der Resistgräben bzw. -löcher; durch Verwendung eines aromatenhaltigen Aufweitungsagens wird eine Ätzresistenz gegen Substratätzprozesse erreicht.

Wird nach der Zweilagenresisttechnik verfahren, dann wird auf das Substrat zunächst ein Bottomresist aufgebracht, d.h. aufgeschleudert. Dieser Bottomresist, der gegen Substratätzprozesse resistent sein muß, weist ein aromatenhaltiges Polymer auf, üblicherweise auf Novolak-Basis. Nach dem Aufschleudern wird der Bottomresist ausgeheizt; dabei erfolgt eine Quervernetzung des Polymers, wodurch dieses für Topresist-Lösungsmittel unlöslich wird. Nach dem Ausheizen wird auf den Bottomresist der Topresist aufgebracht. Dieser muß für die Belichtungswellenlänge transparent sein, eine Ätzresistenz gegen Trockenentwicklung im Sauerstoffplasma ist nicht erforderlich. Nach der Trocknung des Topresists erfolgt - wie vorstehend ausgeführt - eine bildmäßige Belichtung, eine Temperaturbehandlung, eine alkalische Entwicklung und eine chemische Nachbehandlung. Bei der chemischen Nachbehandlung werden die Topresistlinien aufgeweitet, d.h. die Topresistgräben bzw. -löcher verengt; durch Verwendung eines siliciumhaltigen Aufweitungsagens wird gleichzeitig eine Ätzresistenz gegen Trockenentwicklung im Sauerstoffplasma erzeugt. Anschließend erfolgt dann noch die Strukturübertragung in den Bottomresist im anisotropen Sauerstoffplasma.

Anhand von Ausführungsbeispielen soll die Erfindung noch näher erläutert werden. Dabei finden folgende Ausgangsmaterialien bzw. Reagenzien Verwendung (MT = Masseteile):
- Basispolymer (1):
   Copolymer aus Methacrylsäure-tert.-butylester und Maleinsäureanhydrid, hergestellt durch radikalische Polymerisation der beiden Monomere in Toluol mit Azoisobuttersäurenitril als Initiator.
- Basispolymer (2):
   Copolymer aus Acrylsäure-tert.-butylester und Maleinsäureanhydrid, hergestellt durch radikalische Polymerisation der beiden Monomere in Toluol mit Azoisobuttersäurenitril als Initiator.
- Photoaktive Komponente (1):
   Dies ist eine Verbindung, die bei Belichtung eine starke Säure bildet; geeignete Säurebildner sind insbesondere als Crivellosalze bekannte Oniumverbindungen sowie Triazinderivate; zum Einsatz gelangt hier Triphenylsulfonium-trifluormethansulfonat.
- Photoaktive Komponente (2):
   Der Säurebildner ist hierbei Diphenyljodonium-trifluormethansulfonat.
- Entwicklerlösung (1):
   Wäßrige, basisch reagierende Lösung in Form des kommerziellen metallionenfreien Photoresistentwicklers NMD-W 2,38 % (Fa. Tokyo Ohka Kogyo Co.).
- Entwicklerlösung (2):
   Organisches Medium in Form einer Mischung aus 66 MT Xylol und 34 MT Anisol; hiermit können sehr selektiv die unbelichteten, unpolaren Bereiche entwickelt werden, während die belichteten, polaren Bereiche nicht verändert werden.
- Silylierungslösung (1):
   Wäßrig-organische Lösung, bestehend aus 4 MT Diaminosiloxan, 45,7 MT Isopropanol und 50,3 MT Ethanol; vorzugsweise wird ein α,ω-aminofunktionelles Siloxan, insbesondere mit zwei endständigen Aminopropylgruppen und 2 bis 20 Siliciumatomen in der Kette, verwendet, beispielsweise das handelsübliche Produkt Tegomer A-Si 2120 (Fa. Goldschmidt). Als Lösungsmittel für das Siloxan finden vorzugsweise wäßrig-alkoholische Medien Verwendung, insbesondere mit Isopropanol oder Ethanol, denen bei Bedarf noch die Silylierungsgeschwindigkeit erhöhende Additive beigemischt werden können; hierfür haben sich insbesondere Polyethylenglykole und deren Ether bewährt.
- Silylierungslösung (2):
   Wäßrig-organische Lösung, bestehend aus 2 MT Diaminosiloxan (Tegomer A-Si 2120), 95 MT Isopropanol und 3 MT Wasser.
- Silylierungslösung (3):
   Wäßrig-organische Lösung, bestehend aus 4 MT Diaminosiloxan, 75 MT Isopropanol, 15 MT Diethylenglykoldimethylether und 6 MT Wasser.

### Beispiel 1

Auf einen Siliciumwafer (als Substrat) wird der käufliche Positivresist TSMR 8900 (Fa. Tokyo Ohka Kogyo Co.) aufgeschleudert und 1 min bei 90°C getrocknet; dann wird 35 min im Umluftofen bei 240°C ausgeheizt. Nach dem Ausheizen beträgt die Dicke des als Planarisierungsschicht dienenden Resists 1,3 µm.

Auf die Planarisierungsschicht wird ein Photoresist, bestehend aus 11,4 MT Basispolymer (1), 0,6 MT photoaktive Komponente (1) und 88 MT Methoxypropylacetat, aufgeschleudert. Nach Trocknung bei 90°C/60 s auf einer Hotplate beträgt die Schichtdicke dieses Topresists 0,32 µm. Der Resist wird dann durch eine Maske mit 3 mJ/cm² kontaktbelichtet (Gerät MJB 3, Fa. Karl Süss; λ = 250 nm) und 60 s bei 90°C auf der Hotplate getempert. Danach werden die belichteten Bereiche 90 s mit der Entwicklerlösung (1) in einer käuflichen Puddle-Entwicklungsapparatur (Typ CEM 2000, Fa. Convac) bei Raumtemperatur und Normaldruck behandelt und herausgelöst und dann 30 s mit Wasser gespült. Unter gleichen Bedingungen (Raumtemperatur, Normaldruck) werden die verbleibenden Strukturen nachfolgend, ebenfalls in einer kommerziellen Puddle-Entwicklungsapparatur (Typ CEM 2000-U, Fa. Convac), durch Behandeln mit der Silylierungslösung (1) - für die Dauer von 120 s - silyliert und dann 30 s mit Isopropanol gespült. Anschließend wird der Siliciumwafer in eine Plasmaätzanlage (Typ MIE 720, Fa. Material Research Corporation) gebracht und der Resist im Sauerstoffplasma trocken entwickelt (O₂/RIE: 1,9 mTorr Gasdruck, 40 V Biasspannung, 0,9 kW Leistung, mit Magnet; Dauer: 80 s). Es werden 1,6 µm hohe positive Strukturen bis 0,4 µm mit einem Steg/Graben-Verhältnis von 1:1 und senkrechten Flanken erhalten.

### Beispiel 2

Es wird wie in Beispiel 1 vorgegangen, die Belichtung (durch eine Maske) erfolgt jedoch mit 18 mJ/cm² unter Verwendung eines DUV-Steppers (Canon Excimer Laser Stepper FPA 4500; λ = 248 nm, NA = 0,37); Anmerkung: Die für 1:1-Abbildungen benötigte Dosis ist bei Verwendung dieses Steppers stets deutlich höher als bei der Kontaktbelichtung entsprechend Beispiel 1. Nach der Trokkenentwicklung (O₂/RIE: 20 sccm O₂-Fluß, 300 W Leistung, 50 G-Magnet; Dauer: 180 s) in einer Plasmaätzanlage (Precision 5000) werden 1,6 µm hohe positive Strukturen bis 0,3 µm mit einem Steg/Graben-Verhältnis von 1:1 und maßhaltige Kontaktlöcher bis 0,4 µm erhalten; Strukturen und Kontaktlöcher haben 90°-Flanken.

### Beispiel 3

Es wird wie in Beispiel 1 vorgegangen, die Trockenentwicklung in der Plasmaätzanlage (Typ MIE 720, Fa. Material Research Corporation) erfolgt jedoch in einem Zweistufen-Ätzprozeß. Dabei wird zunächst 6 s mit einem Gasgemisch aus Sauerstoff und Tetrafluormethan geätzt (O₂-Fluß: 70 sccm; CF₄-Fluß: 9 sccm; Gesamtgasdruck: 8,1 mTorr; Biasspannung: 40 V; mit Magnet) und dann - entsprechend Beispiel 1 - im reinen Sauerstoffplasma trocken entwickelt (O₂/RIE: 1,9 mTorr Gasdruck, 40 V Biasspannung, 0,9 kW Leistung, mit Magnet; Dauer: 80 s). Es werden positive Strukturen bis 0,4 µm mit senkrechten Flanken und einem Steg/Graben-Verhältnis von 1:1 erhalten.

### Beispiel 4

Es wird wie in Beispiel 2 vorgegangen, die nach dem Entwickeln mit der Entwicklerlösung (1) verbleibenden Strukturen werden jedoch für die Dauer von 200 s mit der Silylierungslösung (1) behandelt. Die verlängerte Silylierung führt dabei - nach der in Beispiel 2 beschriebenen Trockenentwicklung im Sauerstoffplasma - zu einer deutlichen Verengung der Gräben und Kontaktlöcher. So wird beispielsweise statt einer Sequenz von jeweils 0,3 µm breiten Stegen und Gräben eine Sequenz aus 0,45 µm breiten Stegen und 0,15 µm breiten Gräben erhalten. Die erzeugten positiven Strukturen und Kontaktlöcher weisen wiederum senkrechte Flanken auf.

### Beispiel 5

Ein Resist, bestehend aus 13,95 MT Basispolymer (2), 1,05 MT photoaktive Komponente (2) und 85 MT Diethylenglykoldimethylether, wird auf eine Planarisierungsschicht entsprechend Beispiel 1 aufgeschleudert und 60 s bei 100°C getrocknet; dieser Topresist weist dann eine Dicke von 0,32 µm auf. Nach Belichtung des Resists durch eine Maske mit 6 mJ/cm² (Canon Excimer Laser Stepper FPA 4500; λ = 248 nm, NA = 0,37) wird 60 s bei 110°C getempert, dann werden die belichteten Bereiche durch Behandeln mit der Entwicklerlösung (1) bei Raumtemperatur und Normaldruck - für die Dauer von 60 s - in einer Puddle-Entwicklungsapparatur (Typ CEM 2000, Fa. Convac) herausgelöst; anschließend wird 30 s mit Wasser gespült. Die verbleibenden Strukturen werden in einer Puddle-Entwicklungsapparatur (Typ CEM 2000-U, Fa. Convac), bei Raumtemperatur und Normaldruck, 60 s mit der Silylierungslösung (2) behandelt und 30 s mit Isopropanol gespült. Nach der Trockenentwicklung des Resists (O₂/RIE: 20 sccm O₂-Fluß, 300 W Leistung, 50 G-Magnet; Dauer: 180 s) in einer Plasmaätzanlage (Precision 5000) werden positive Strukturen bis 0,3 µm (Steg/Graben-Verhältnis 1:1) und maßhaltige 0,4 µm-Kontaktlöcher mit senkrechten Flanken erhalten.

### Beispiel 6

Es wird wie in Beispiel 5 vorgegangen, die Silylierungsdauer (in der Puddle-Entwicklungsapparatur) wird jedoch auf 100 s verlängert. Dadurch werden die Gräben nach einer entsprechenden Trockenentwicklung - im Vergleich mit den Ergebnissen nach Beispiel 5 - verengt, d.h. anstatt von 0,4 µm-Kontaktlöchern werden 0,3 µm-Kontaktlöcher mit senkrechten Flanken erhalten.

### Beispiel 7

Ein Resist entsprechend Beispiel 1 wird, wie dort beschrieben, auf die Planarisierungsschicht aufgeschleudert und getrocknet. Nach einer Kontaktbelichtung (Gerät MJB 3, Fa. Karl Süss; λ = 250 nm) durch eine Maske mit 1,8 mJ/cm² wird 60 s bei 110°C getempert; durch eine Behandlung (Puddle-Entwicklungsapparatur entsprechend Beispiel 1; Raumtemperatur, Normaldruck) mit der Entwicklerlösung (2) für die Dauer von 60 s werden die unbelichteten Bereiche selektiv herausgelöst; dann wird 30 s mit Isopropanol gespült. In der gleichen Apparatur und unter gleichen äußeren Bedingungen werden anschließend die verbleibenden negativen Strukturen 60 s mit der Silylierungslösung (3) behandelt, dann wird 30 s mit Isopropanol gespült. Nach der Trockenentwicklung des Resists (O₂/RIE: 2 mTorr Gasdruck, 50 V Biasspannung, 0,9 kW Leistung, mit Magnet) in einer Plasmaätzanlage (Typ MIE 720, Fa. Material Research Corporation) werden negative Strukturen bis 0,4 µm mit senkrechten Flanken und einem Steg/Graben-Verhältnis von 1:1 erhalten; die Strukturen weisen eine Höhe von 1,6 µm auf.

### Beispiel 8

Ein Resist, bestehend aus 21,85 MT Basispolymer (2), 1,15 MT photoaktive Komponente (1) und 77 MT Methoxypropylacetat, wird auf einen Siliciumwafer aufgeschleudert und 60 s bei 90° getrocknet. Danach wird der Resist, ohne vorangegangene Belichtung, entsprechend Beispiel 1 in einer Puddle-Entwicklungsapparatur (Raumtemperatur, Normaldruck) 360 s mit der Silylierungslösung (1) behandelt, dann wird 30 s mit Isopropanol gespült und getrocknet. Der Wafer wird anschließend in eine Plasmaätzanlage (Typ MIE 720, Fa. Material Research Corporation) gebracht und 200 s im Sauerstoffplasma trocken geätzt (O₂/RIE: 1,9 mTorr Gasdruck, 40 V Biasspannung, 0,9 kW Leistung, mit Magnet). Aus der Schichtdickenmessung vor und nach der Ätzung errechnet sich eine Abtragsrate der silylierten Schicht von 0,73 nm/s. Dabei ist ohne Einfluß, ob der unbelichtete Resist vor der Silylierung mit der Entwicklerlösung (1) behandelt wurde oder nicht.

Werden Resists, wie sie aus dem Stand der Technik bekannt sind (siehe EP-OS 0 388 484 und 0 395 917), wie dort angegeben silyliert (siehe die entsprechenden Ausführungsbeispiele) und die silylierten Schichten unter den vorstehend beschriebenen Bedingungen geätzt, dann werden - bei den silylierten Schichten Abtragsraten gemessen, die in allen Fällen zwischen 0,95 und 1,05 nm/s liegen. Die im Rahmen der vorliegenden Patentanmeldung erzeugten siliciumhaltigen Schichten zeigen - im Vergleich zum Stand der Technik - im allgemeinen eine ca. 30 % höhere Ätzresistenz bei der Trockenentwicklung im Sauerstoffplasma (O₂/RIE).

## Patentansprüche

1. Photoresist zur Strukturerzeugung im Submikron-Bereich,
**dadurch gekennzeichnet**, daß er folgende Komponenten enthält:
- eine Polymerkomponente mit Carbonsäureanhydridfunktionen und Carbonsäure-tert.-butylestergruppen,
- einen bei Belichtung eine Säure freisetzenden Photoinitiator und
- ein geeignetes Lösungsmittel.

2. Photoresist nach Anspruch 1, **dadurch gekennzeichnet**, daß den Carbonsäureanhydridfunktionen Maleinsäureanhydrid zugrunde liegt.

3. Photoresist nach Anspruch 1, **dadurch gekennzeichnet**, daß den Carbonsäure-tert.-butylestergruppen Acrylsäure-, Methacrylsäure-, Maleinsäure- oder Fumarsäure-tert.-butylester zugrunde liegt.

4. Photoresist nach einem der Ansprüche 1 bis 3, **dadurch gekennzeichnet**, daß die Polymerkomponente ein Acrylsäure- oder Methacrylsäure-tert.-butylester/ Maleinsäureanhydrid-Copolymer ist.

5. Photoresist nach einem der Ansprüche 1 bis 3, **dadurch gekennzeichnet**, daß die Polymerkomponente ein Terpolymer aus einem tert.-Butylester einer ungesättigten Carbonsäure, Maleinsäureanhydrid und Allyltrimethylsilan oder Styrol ist.

6. Photoresist nach einem oder mehreren der Ansprüche 1 bis 5, **dadurch gekennzeichnet**, daß der Photoinitiator ein Oniumsalz ist, insbesondere Diphenyljodoniumoder Triphenylsulfonium-trifluormethansulfonat.

7. Photoresist nach einem oder mehreren der Ansprüche 1 bis 6, **dadurch gekennzeichnet**, daß das Lösungsmittel Cyclohexanon oder Methoxypropylacetat ist.

8. Photoresist nach einem oder mehreren der Ansprüche 1 bis 7, **dadurch gekennzeichnet**, daß er zusätzlich einen Sensibilisator, insbesondere Perylen, enthält.

9. Verwendung des Photoresists nach einem oder mehreren der Ansprüche 1 bis 8 in der Einlagenresisttechnik.

10. Verwendung des Photoresists nach einem oder mehreren der Ansprüche 1 bis 8 zur maßhaltigen Strukturübertragung in der Zweilagentechnik oder zur Erzeugung von Strukturen jenseits der Auflösungsgrenze.

## Claims

1. A photoresist for the production of structures in the submicron range, characterised in that it contains the following components:
- a polymer component with carboxylic acid anhydride functions and carboxylic acid tert. butyl ester groups,
- a photoinitiator which releases an acid upon exposure and
- a suitable solvent.

2. A photoresist as claimed in Claim 1, characterised in that the carboxylic acid anhydride functions are based on maleic acid anhydride.

3. A photoresist as claimed in Claim 1, characterised in that the carboxylic acid tert. butyl ester groups are based on acrylic acid-, methacrylic acid-, maleic acid-or fumaric acid tert. butyl ester.

4. A photoresist as claimed in one of Claims 1 to 3, characterised in that the polymer component is an acrylic acid- or methacrylic acid tert. butyl ester / maleic acid anhydride copolymer.

5. A photoresist as claimed in one of Claims 1 to 3, characterised in that the polymer component is a terpolymer of a tert. butyl ester of an unsaturated carboxylic acid, maleic acid anhydride and allyl trimethyl silane or styrene.

6. A photoresist as claimed in one or more of Claims 1 to 5, characterised in that the photoinitiator is an onium salt, in particular diphenyl iodonium- or triphenyl sulfonium-trifluoromethane sulfonate.

7. A photoresist as claimed in one or more of Claims 1 to 6, characterised in that the solvent is cyclohexanone or methoxypropyl acetate.

8. A photoresist as claimed in one or more of Claims 1 to 7, characterised in that it additionally contains a sensitizer, in particular perylene.

9. The use of the photoresist as claimed in one or more of Claims 1 to 8 in single-layer resist technology.

10. The use of the photoresist as claimed in one or more of Claims 1 to 8 for the true-to-size transfer of structures in two-layer technology or for the production of structures beyond the resolution limit.

## Revendications

1. Photoréserve pour la fabrication de structures dans la plage du sous-micron, caractérisée en ce qu'elle contient les composants suivants :
- un composant polymère avec des fonctions anhydride d'acide carboxylique et des groupes de tert-butylester d'acide carboxylique,
- un photoinitiateur dégageant un acide lors de l'exposition
et
- un solvant approprié.

2. Photoréserve selon la revendication 1, caractérisée en ce que l'anhydride de l'acide maléique est à la base des fonctions anhydride d'acide carboxylique.

3. Photoréserve selon la revendication 1, caractérisée en ce que le tert-butylester d'acide acrylique, d'acide méthacrylique, d'acide maléique ou d'acide fumarique est à la base des groupes tert-butylester d'acide carboxylique.

4. Photoréserve selon l'une des revendications 1 à 3, caractérisée en ce que le composant polymère est un copolymère de tert-butylester d'acide acrylique ou d'acide méthacrylique et de l'anhydride d'acide maléique.

5. Photoréserve selon l'une des revendications 1 à 3, caractérisée en ce que le composant polymère est un terpolymère de tert-butylester d'un acide carboxylique non saturé, de l'anhydride d'acide maléique et de l'allyltriméthylsilane ou de styrène.

6. Photoréserve selon l'une ou plusieurs des revendications 1 à 5, caractérisée en ce que le photoinitiateur est un sel onium, en particulier le trifluorométhanesulfonate de diphényliodonium ou de triphénylsulfonium.

7. Photoréserve selon l'une ou plusieurs des revendications 1 à 6, caractérisée en ce que le solvant est du cyclohexanone ou du méthoxypropylacétate.

8. Photoréserve selon l'une ou plusieurs des revendications 1 à 7, caractérisée en ce qu'elle contient en outre un sensibilisateur, en particulier du pérylène.

9. Utilisation de la photoréserve selon l'une ou plusieurs des revendications 1 à 8 dans la technique de la réserve à une couche.

10. Utilisation de la photoréserve selon l'une ou plusieurs des revendications 1 à 8 pour le transfert exact des structures dans la technique à deux couches ou pour la fabrication de structures au-delà de la limite de résolution.
